# EUROPEAN PATENT SPECIFICATION

(11) **EP 3 725 945 B1**
(45) Date of publication and mention of the grant of the patent: **30.04.2025**
(21) Application number: 19886428.2
(22) Date of filing: 20.11.2019
(51) Int. Cl.: B32B 33/00, E01C 23/08, B32B 37/10, B32B 37/24, B32B 38/00, B32B 27/08, B32B 27/30, B32B 27/38, B32B 27/40, B41M 5/00, B41M 7/00, E04F 15/10, B41M 3/06

(54) **METHOD FOR FORMING THREE-DIMENSIONAL TEXTURE ON PLASTIC FLOOR**
VERFAHREN ZUR HERSTELLUNG EINER DREIDIMENSIONALEN TEXTUR AUF EINEM KUNSTSTOFFBODEN
PROCÉDÉ DE FORMATION DE TEXTURE TRIDIMENSIONNELLE SUR SOL EN PLASTIQUE

(30) Priority: 22.11.2018 CN 201811395863
(43) Date of publication of application: 21.10.2020
(73) Proprietor: Zhejiang Kingdom Plastics Industry Co., Ltd., Jiaxing, Zhejiang 314500 (CN)
(72) Inventor: DAI, Huibin, Jiaxing, Zhejiang 314500 (CN); ZHAO, Peidong, Jiaxing, Zhejiang 314500 (CN); ZHANG, Zhongfei, Jiaxing, Zhejiang 314500 (CN)
(74) Representative: Loo, Chi Ching
(86) International application number: PCT/CN2019/119623
(87) International publication number: WO 2020/103850

(56) References cited:
- EP-A1- 0 520 151
- EP-A1- 2 913 199
- EP-A1- 3 042 785
- EP-A1- 3 173 229
- EP-A2- 2 507 063
- EP-B1- 2 507 063
- WO-A1-2017/121499
- BE-A- 778 447
- CN-A- 1 947 998
- CN-A- 103 827 414
- CN-A- 104 354 485
- CN-A- 109 537 421
- CN-U- 204 311 690
- GB-A- 2 545 085
- KR-A- 20110 115 269
- KR-B1- 101 780 678
- US-A1- 2011 011 020
- US-A1- 2014 028 772

## Description

### TECHNICAL FIELD

This disclosure generally relates to the technical field of floor boards, and more particularly, to a method for forming stereoscopic patterns of plastic floor boards.

### BACKGROUND

As using plastic material instead of natural timbers significantly reduces damage to the environment, the development of plastic floor has become a trend. To make the plastic floor aesthetically appealing, various patterns are printed on a printing layer. In the prior art, the patterns of conventional plastic floor boards are normally pre-printed on the printing layer, which is roll-pressed into a whole along with a base layer and a wear layer during the subsequent process. The visual effect of the flat pattern printed on the printing layer is poor. To improve this, a stereoscopic pattern is formed on the wear layer. However, the flat pattern on the printing layer does not accurately correspond to the stereoscopic pattern on the wear layer, resulting in the failure of achieving an integral stereoscopic effect. In addition, the printed pattern on the plastic floor board is fixed, making the pattern's customization impossible. Thus, it is urgent for those skilled in the art to provide a novel method. An example of a method for forming patterns on plastic flooring can be found in KR20110115269.

### SUMMARY

The purpose of the present disclosure is to provide a method for forming stereoscopic patterns of plastic floor boards, which designs and forms various patterns according to users' needs, makes the stereoscopic patterns more aesthetically appealing, improves the production efficiency and ensures the stability of quality.

A first aspect of the present invention is set out in independent claim 1. Optional features are as disclosed in dependent claims 2 to 8.

Compared with the prior art, the present disclosure has the following advantages: through adopting the method of the present disclosure, various patterns may be designed and formed according to users' needs, the stereoscopic patterns become more aesthetically appealing, the production efficiency is improved and the stability of quality is ensured.

### BRIEF DESCRIPTION OF THE FIGURES

Figure 1 is a plan view illustrating the equipment of an embodiment of the present disclosure;
Figure 2 is a plan view illustrating the equipment of another embodiment of the present disclosure;
Figure 3 is a plan view illustrating the equipment of another embodiment of the present disclosure;
Figure 4 is an enlarged conceptual diagram illustrating the pressing mechanism of the present disclosure;
Figure 5 is a conceptual diagram illustrating the arrangement of positioning points of the present disclosure;
Figure 6 is a sectional view illustrating a finished plastic floor board of the present disclosure.

### DETAILED DESCRIPTION

Figures and detailed embodiments are combined hereinafter to further elaborate the technical solution of the present disclosure.

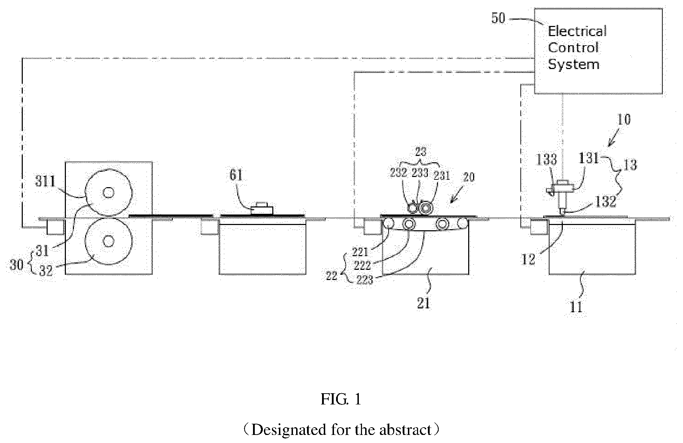

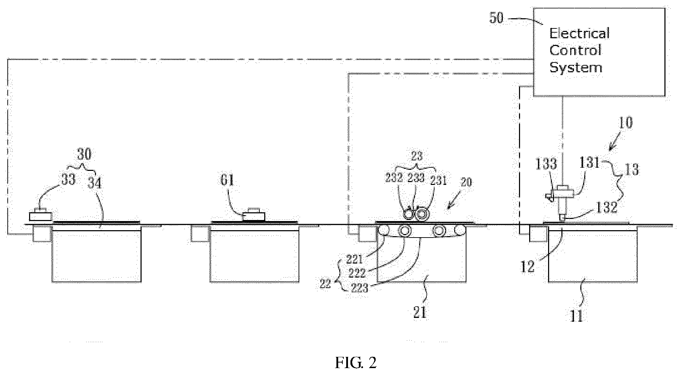

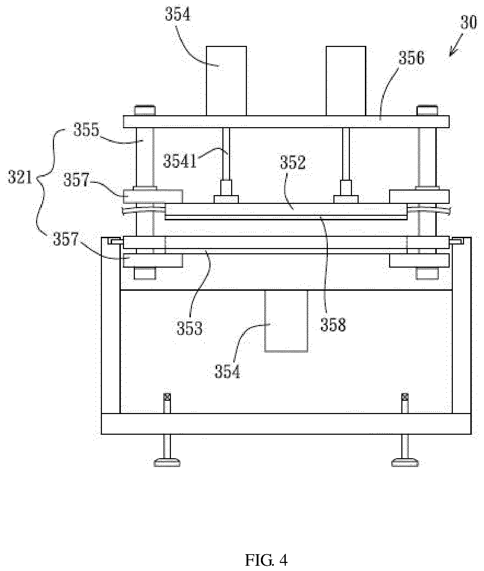

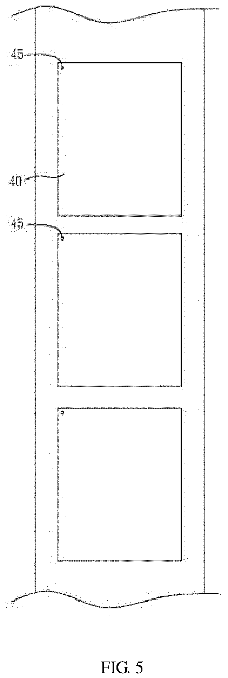

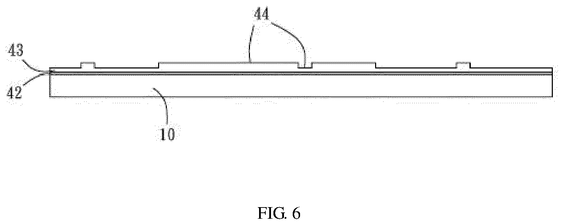

As shown in Figures 1-6, a method for forming stereoscopic patterns of plastic floor boards comprises machinery equipment including at least one digital printing unit 10, a first forming unit 20 and a second forming unit 30, wherein the aforesaid equipment is utilized to perform a series of processes to a base board 40, thereby forming the stereoscopic pattern of the plastic floor board. The aforesaid forming method comprising the steps of:
Step A: taking a base board 40, wherein the base board is normally used as the bottom material of a plastic floor board, has a blank or plain outer surface 41, and may be continuously extrusion-formed using an extruder or cut into individual boards after machine forming.

Step B: digital printing: positioning the base board 40 on the digital printing unit 10, and printing a pattern layer 42 on the base board 40, wherein the digital printing unit 10 comprises a first machine body 11, a first conveying platform 12 arranged on the first machine body 11, and a printing mechanism 13 correspondingly arranged above the first conveying platform 12, wherein the printing mechanism 13 comprises a collecting seat 131, one end of the collecting seat 131 is connected to a source for supplying the pigment, and the other end of the collecting seat 131 is provided with a discharging portion 132 for discharging the pigment, wherein the printing mechanism 13 may be controlled by an electrical control system 50, wherein a sensing unit 133 is arranged at a proper position, and the sensing unit 133 is electrically connected to the electrical control system 50. When the base board 40 is conveyed to a particular position, the electrical control system 50 receives a signal from the sensing unit 133, and the printing mechanism 13 is controlled to print the pigment on the outer surface 41 of the base board 40 through the discharging portion 132 according to the pattern preset in the electrical control system 50. Thus, a pattern layer 42 is formed. When a thicker pattern layer 42 is required, step B may be repeated for 2-3 times to achieve a pattern layer with a specific height.

Step C: forming a protection layer 43: forming a protection layer 43 on the pattern layer 42 using a transparent melt plastic raw material by the first forming unit 20, wherein the plastic material used as the protection layer may be a UV coating, a PVC material or a PUR coating. As shown in Figures 1-2, the first forming unit 20 comprises a second machine body 21, a second conveying platform 22 arranged on the second machine body 21, and a coating mechanism 23 correspondingly arranged above the second conveying platform 22, wherein the second conveying platform 22 further comprises two conveying wheels 221, a plurality of rolling wheels 222 and a conveying belt 223, wherein the coating mechanism 23 comprises a main roll 231 and an auxiliary roll 232, and a receiving portion 233 is arranged between the two rolls for receiving the melt plastic raw material. During operation, the coating mechanism 23 is controlled by the electrical control system 50. When the base board 40 is conveyed to a particular position, the melt plastic raw material in the receiving portion 233 is coated on the pattern layer 42 along the rotation of the main roll 231. Moreover, through the auxiliary roll 232 and the main roll 231 that rotate in opposite directions, the coating of the melt plastic raw material becomes more uniform. After being coated on the pattern layer 42, the melt plastic raw material may be irradiated by a drying apparatus 61 such as a UV lamp, thus accelerating the drying and hardening of the melt plastic raw material. Furthermore, when a thicker protection layer 43 is required, step C may be repeated for 2-3 times to achieve a protection layer with a specific height.

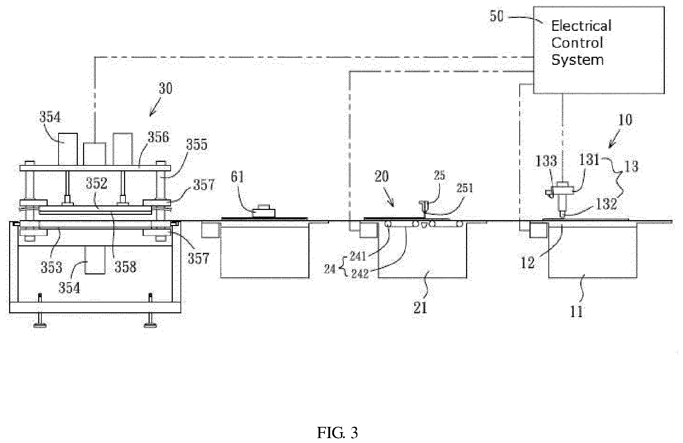

In addition, as shown in Figure 3, the first forming unit 20 comprises a third conveying platform 24 arranged on the second machine body 21 and a shower-coating mechanism 25 correspondingly arranged above the third conveying platform 24. The third conveying platform 24 comprises a plurality of conveying wheels 241 capable of propelling the conveying belt to rotate. The lower end of the shower-coating mechanism 25 is provided with a discharging port 251 whose interior allows the melt plastic raw material to flow therein. The melt plastic raw material is vertically discharged from the discharging port 251 in a shower manner. When the base board 40 is conveyed through the lower portion of the shower-coating mechanism 25, the melt plastic raw material is coated on the pattern layer 42. Alternatively, the first forming unit 20 may adopt a digital printer (not shown) to form a protection layer by printing.

Step D: forming a stereoscopic pattern 44: forming a stereoscopic pattern 44 on the protection layer 43 by the second forming unit 30, thus forming the plastic floor board with a stereoscopic pattern, wherein the second forming unit 30 may differ in different embodiments.

As an alternative, the second forming unit 30 may comprise two roll wheels, wherein an embossing pattern 311 having a concave-convex structure is formed on one of the roll wheels 31. The concave-convex structure of the embossing pattern 311 is designed to correspond to a particular portion of the pattern layer 42. For instance, when the pattern of the pattern layer 42 is a tree or wood grain, to make a tree burl or the wood grain raise properly, the embossing pattern 311 designed to correspond to the tree burl or wood grain is a recessed structure. According to this design, after the base board 40 passes through the two roll wheels 31 and 32, a stereoscopic pattern 44 with a concave-convex structure is formed on the protection layer 43.

Alternatively, the second forming unit 30 may be a second coating mechanism 33 arranged on a platform 34, wherein one end of the second coating mechanism 33 is connected to a source for supplying the melt plastic raw material, and the other end of the second coating mechanism 33 outputs the melt plastic raw material. The second coating mechanism 33 is controlled by the electrical control system 50. After the protection layer 43 is dried, a stereoscopic pattern 44 with a raised structure is formed on the protection layer 43 through roll-coating or spray-coating.

Alternatively, the second forming unit 30 may be a pressing mechanism, which comprises a mold frame 351. An upper mold holder 352, a lower mold holder 353 and two power sources 354 are arranged on the mold frame 351. The mold frame 351 comprises a plurality of guide rods 355 penetrating through a positioning plate 356 located above the guide rods 355, and a plurality of connecting plates 357 connected to the upper mold holder 352 and the lower mold holder 353. The two power sources 353 are fixedly arranged on the positioning plate 356. One end of each power source 354 is provided with a telescopic shaft 3541, and one end of the telescopic shaft 3541 is fixedly connected with the outer surface of the upper mold holder 352. According to the aforesaid, when the two power sources 354 work, the upper mold holder 352 is propelled to move up and down. Additionally, a movable mold plate 358 is arranged on the outer surface of the upper mold holder 352 that corresponds to the lower mold holder 353, and an embossing pattern (not shown) is formed on the outer surface of the mold plate 358. The embossing pattern has a concave-convex structure, which is designed to correspond to a particular portion of the pattern layer 42. When the base board 40 is conveyed to or placed at a position under the mold plate 358, the two power sources 354 are initiated to propel the upper mold holder 352, thus enabling the upper mold holder 352 to press downwards. In this way, the mold plate 358 presses the protection layer 43 of the base board 40 so that the stereoscopic pattern 44 is formed.

In actual application of the second forming unit 30, when forming a stereoscopic pattern 44 on the base board 40 using the roll wheels 31-32 or the pressing mechanism, the base board 40 may be positioned at a particular position and a positioning point 45 may be pre-arranged at a proper position on the base board 40, or a plurality of positioning points are arranged on the base board at equal intervals. When a positioning point 45 is detected by the electrical control system 50, the second forming unit 30 is initiated to form a stereoscopic pattern 44 having a concave-convex structure on the protection layer 43, and each stereoscopic pattern 44 is formed at a particular position on the corresponding pattern layer 42 through positioning the positioning point 45. Thus, the stereoscopic pattern accurately corresponds to the flat pattern on the pattern layer, achieving an integral stereoscopic visual effect.

The forming method of the present disclosure allows the patterns of the floor boards to be designed and formed according to users' needs, improves the production efficiency and makes the product quality stable.

Additionally, the interior of the upper mold holder 352 and the lower mold holder 353 may be provided with an electric heater to produce heat, or a circulation loop may be installed to guide the hot oil to circulate to produce heat. The heating system transmits the heat to the mold plate 358, which enables the movable pressing mechanism to form an embossing pattern through hot-pressing, and to press the plastic floor board materials into a whole. Alternatively, in this process, if the temperature of the extrusion-formed base board 40 is high, the hot-pressing is no longer needed. Instead, cooling water may be supplied to the circulation loops of the upper mold holder 352 and the lower mold holder 353 for cooling. The cooled mold plate 358 allows the movable pressing mechanism 30 to form an embossing pattern through cold-pressing, and to presses the plastic floor board materials into a whole.

Through the aforesaid improvements, various patterns may be designed and formed according to users' needs, the stereoscopic patterns become more aesthetically appealing, the production efficiency is improved and the stability of quality is ensured.

## Claims

1. A method for forming stereoscopic patterns (44) of plastic floor boards, comprising the steps of:
Step A: taking a base board (40), which has a blank or plain outer surface (41);
Step B: digital printing: positioning the base board (40) on a digital printing unit (10), and using the digital printing unit (10) to print the pigment on the outer surface (41) of the base board (40) according to the preset pattern, thereby forming a pattern layer (42), wherein the pattern of the pattern layer (42) corresponds to or does not correspond to the stereoscopic pattern (44);
Step C: forming a protection layer (43): using a first forming unit (20) to form a protection layer (43) on the pattern layer (42) with a transparent melt plastic raw material;
Step D: forming a stereoscopic pattern (44): using a second forming unit (30) to form a stereoscopic pattern (44) having a concave-convex structure on the protection layer (43), thus forming the plastic floor board with a stereoscopic pattern (44);
wherein the first forming unit (20) comprises a second machine body (21),
a second conveying platform (22) arranged on the second machine body (21), and a coating mechanism (23) correspondingly arranged above the second conveying platform (22), wherein the second conveying platform (22) further comprises two conveying wheels (221), a plurality of rolling wheels (222) and a conveying belt (223), wherein the coating mechanism (23) comprises a main roll (231) and an auxiliary roll (232), and a receiving portion (233) is arranged between the two rolls for receiving the melt plastic raw material, wherein the coating mechanism (23) is controlled by the electrical control system (50), wherein when the base board (40) is conveyed to a particular position, the melt plastic raw material in the receiving portion (233) is coated on the pattern layer (42) along the rotation of the main roll (231), wherein through the auxiliary roll (232) and the main roll (231) that rotate in opposite directions, the coating of the melt plastic raw material becomes more uniform;
a third conveying platform (24) arranged on the second machine body (21) and a shower-coating mechanism (25) correspondingly arranged above the third conveying platform (24), wherein the third conveying platform (24) comprises a plurality of conveying wheels (241) capable of propelling the conveying belt (233) to rotate, wherein the lower end of the shower-coating mechanism (25) is provided with a discharging port (251) whose interior allows the melt plastic raw material to flow therein, wherein the melt plastic raw material is vertically discharged from the discharging port (251) in a shower manner, wherein when the base board (40) is conveyed through the lower portion of the shower-coating mechanism (25), the melt plastic raw material is coated on the pattern layer (42).

2. The method for forming stereoscopic patterns (44) of plastic floor boards of claim 1, wherein the plastic material used as the protection layer (43) is a UV coating, a PVC material or a PUR coating.

3. The method for forming stereoscopic patterns (44) of plastic floor boards of claim 1, wherein when printing the pigment on the outer surface (41) of the base board (40) by a digital printing unit (10), step B may be repeated to achieve a pattern layer (42) with a specific height.

4. The method for forming stereoscopic patterns (44) of plastic floor boards of claim 1, wherein the second forming unit (30) comprises two roll wheels (31, 32), and an embossing pattern (311) having a concave-convex structure is formed on one of the roll wheels, wherein the concave-convex structure of the embossing pattern (311) is designed to correspond to a particular portion of the pattern layer (42), wherein after the base board (40) passes through the second forming unit (30), a stereoscopic pattern (44) with a concave-convex structure is formed on the protection layer (43).

5. The method for forming stereoscopic patterns (44) of plastic floor boards of claim 1, wherein the second forming unit (30) is a second coating mechanism (33) arranged on a platform (34), wherein one end of the second coating mechanism (33) is connected to a source for supplying the melt plastic raw material, and the other end of the second coating mechanism (33) outputs the melt plastic raw material, wherein the second coating mechanism (33) is controlled by the electrical control system (50), wherein after the protection layer (43) is dried, a stereoscopic pattern (44) with a raised structure is formed on the protection layer (43) through roll-coating or spray-coating.

6. The method for forming stereoscopic patterns (44) of plastic floor boards of claim 5, wherein the second forming unit (30) is a pressing mechanism, which comprises a mold frame (351), wherein an upper mold holder (352), a lower mold holder (353) and two power sources (354) are arranged on the mold frame (351), wherein the mold frame (351) comprises a plurality of guide rods (355) penetrating through a positioning plate (356) located above the guide rods (355), and a plurality of connecting plates (357) connected to the upper mold holder (352) and the lower mold holder (353), wherein the two power sources (353) are fixedly arranged on the positioning plate (356), wherein one end of each power source (353) is provided with a telescopic shaft (3541), and one end of the telescopic shaft (3541) is fixedly connected with the outer surface of the upper mold holder (352), wherein when the two power sources (354) operate, the upper mold holder (352) is propelled to move up and down, wherein a movable mold plate (358) is arranged on the outer surface of the upper mold holder (352) that corresponds to the lower mold holder (353), and an embossing pattern is formed on the outer surface of the mold plate (358), wherein the embossing pattern has a concave-convex structure, which is designed to correspond to a particular portion of the pattern layer (42).

7. The method for forming stereoscopic patterns (44) of plastic floor boards of claim 1 or 3, wherein the digital printing unit (10) comprises a first machine body (11), a first conveying platform (12) arranged on the first machine body (11), and a printing mechanism (13) correspondingly arranged above the first conveying platform (12), wherein the printing mechanism (13) comprises a collecting seat (131), one end of the collecting seat (131) is connected to a source for supplying the pigment, and the other end of the collecting seat (131) is provided with a discharging portion (132) for discharging the pigment, wherein the printing mechanism (13) is controlled by the electrical control system (50), wherein when the base board (40) is conveyed to a particular position, the printing mechanism (13) is controlled to print the pigment on the outer surface (41) of the base board (40) through the discharging portion (132) according to the pattern preset in the electrical control system (50), thereby forming a pattern layer (42).

8. The method for forming stereoscopic patterns (44) of plastic floor boards of claim 1, 4 or 5, wherein when forming a stereoscopic pattern (44) on the base board (40) by the second forming unit (30), the base board (40) is positioned at a particular position, wherein a positioning point (45) is pre-arranged at a proper position on the base board (40), or a plurality of positioning points are arranged on the base board (40) at equal intervals, wherein when a positioning point (45) is detected by the electrical control system (50), the second forming unit (30) is controlled to form a stereoscopic pattern (44) having a concave-convex structure on the protection layer (43), and each stereoscopic pattern (44) is formed at a particular position on the corresponding pattern layer (42) through positioning the positioning point (45).

## Patentansprüche

1. Verfahren zum Formen von stereoskopischen Mustern (44) von Kunststoffbodenbrettern, umfassend die Schritte:
Schritt A: Nehmen eines Basisbretts (40), das eine blanke oder schlichte Außenfläche (41) aufweist;
Schritt B: Digitales Bedrucken: Positionieren des Basisbretts (40) auf einer Digitaldruckeinheit (10) und Verwenden der Digitaldruckeinheit (10) zum Drucken des Pigments auf die Außenfläche (41) des Basisbretts (40) gemäß dem voreingestellten Muster, wodurch eine Musterschicht (42) geformt wird, wobei das Muster der Musterschicht (42) dem stereoskopischen Muster (44) entspricht oder nicht entspricht;
Schritt C: Formen einer Schutzschicht (43): Verwenden einer ersten Formungseinheit (20), um mit einer transparenter Kunststoffrohstoffschmelze eine Schutzschicht (43) auf der Musterschicht (42) zu formen;
Schritt D: Formen eines stereoskopischen Musters (44): Verwenden einer zweiten Formungseinheit (30), um ein stereoskopisches Muster (44) mit einer konkav-konvexen Struktur auf der Schutzschicht (43) zu formen, wodurch das Kunststoffbodenbrett mit einem stereoskopischen Muster (44) geformt wird;
wobei die erste Formungseinheit (20) einen zweiten Maschinenkörper (21), eine zweite Förderplattform (22), die auf dem zweiten Maschinenkörper (21) eingerichtet ist, und einen Beschichtungsmechanismus (23), der entsprechende über der zweiten Förderplattform (22) eingerichtet ist, wobei die zweite Förderplattform (22) weiterhin zwei Förderräder (221), eine Vielzahl von rollenden Rädern (222) und ein Förderband (223) umfasst, wobei der Beschichtungsmechanismus (23) eine Hauptwalze (231) und eine Hilfswalze (232) umfasst und ein Aufnahmeteil (233) zwischen den zwei Walzen zum Aufnehmen der Kunststoffrohstoffschmelze eingerichtet ist, wobei der Beschichtungsmechanismus (23) von dem elektrischen Steuersystem (50) gesteuert wird, wobei, wenn das Basisbrett (40) zu einer bestimmten Position befördert wird, die Kunststoffrohstoffschmelze in dem Aufnahmeteil (233) auf die Musterschicht (42) entlang der Drehung der Hauptwalze (231) beschichtet wird, wobei die Beschichtung der Kunststoffrohstoffschmelze dadurch, dass die Hilfswalze (232) und die Hauptwalze (231) sich in entgegengesetzten Richtungen drehen, gleichmäßiger wird;
eine dritte Förderplattform (24), die auf dem zweiten Maschinenkörper (21) eingerichtet ist, und einen Duschbeschichtungsmechanismus (25), der entsprechend über der dritten Förderplattform (24) eingerichtet ist, umfasst, wobei die dritte Förderplattform (24) eine Vielzahl von Förderrädern (241) umfasst, die dazu in der Lage sind, das Förderband (233) dazu anzutreiben, sich zu drehen, wobei das untere Ende des Duschbeschichtungsmechanismus (25) mit einer Austragsöffnung (251) versehen ist, dessen Inneres ermöglicht, dass die Kunststoffrohstoffschmelze darin fließt, wobei die Kunststoffrohstoffschmelze vertikal in der Weise einer Dusche aus der Austragsöffnung (251) ausgetragen wird, wobei, wenn das Basisbrett (40) durch den unteren Teil des Duschbeschichtungsmechanismus (25) befördert wird, die Kunststoffrohstoffschmelze auf die Musterschicht (42) beschichtet wird.

2. Verfahren zum Formen von stereoskopischen Mustern (44) von Kunststoffbodenbrettern nach Anspruch 1, wobei das als die Schutzschicht (43) verwendete Kunststoffmaterial eine UV-Beschichtung, ein PVC-Material oder eine PUR-Beschichtung ist.

3. Verfahren zum Formen von stereoskopischen Mustern (44) von Kunststoffbodenbrettern nach Anspruch 1, wobei, wenn das Pigment durch eine Digitaldruckeinheit (10) auf die Außenfläche (41) des Basisbretts (40) gedruckt wird, Schritt B wiederholt werden kann, um eine Musterschicht (42) mit einer spezifischen Höhe zu erzielen.

4. Verfahren zum Formen von stereoskopischen Mustern (44) von Kunststoffbodenbrettern nach Anspruch 1, wobei die zweite Formungseinheit (30) zwei Rollräder (31, 32) umfasst und ein Prägemuster (311) mit einer konkav-konvexen Struktur auf einem der Rollräder geformt ist, wobei die konkav-konvexe Struktur des Prägemusters (311) dazu entworfen ist, einem bestimmten Teil der Musterschicht (42) zu entsprechen, wobei, nachdem das Basisbrett (40) die zweite Formungseinheit (30) durchlaufen hat, ein stereoskopisches Muster (44) mit einer konkav-konvexen Struktur auf der Schutzschicht (43) geformt wird.

5. Verfahren zum Formen von stereoskopischen Mustern (44) von Kunststoffbodenbrettern nach Anspruch 1, wobei die zweite Formungseinheit (30) ein zweiter Beschichtungsmechanismus (33) ist, der auf einer Plattform (34) eingerichtet ist, wobei ein Ende des zweiten Beschichtungsmechanismus (33) mit einer Quelle zum Zuführen der Kunststoffrohstoffschmelze verbunden ist und das andere Ende des zweiten Beschichtungsmechanismus (33) die Kunststoffrohstoffschmelze ausgibt, wobei der zweite Beschichtungsmechanismus (33) von dem elektrischen Steuersystem (50) gesteuert wird, wobei, nachdem die Schutzschicht (43) getrocknet ist, ein stereoskopisches Muster (44) mit einer erhabenen Struktur durch Walzenbeschichtung oder Sprühbeschichtung auf der Schutzschicht (43) geformt wird.

6. Verfahren zum Formen von stereoskopischen Mustern (44) von Kunststoffbodenbrettern nach Anspruch 5, wobei die zweite Formungseinheit (30) ein Druckmechanismus ist, der einen Gussformrahmen (351) hält, wobei eine obere Gussformhalterung (352), eine untere Gussformhalterung (353) und zwei Energiequellen (354) an dem Gussformrahmen (351) eingerichtet sind, wobei der Gussformrahmen (351) eine Vielzahl von Führungsstangen (355), die durch eine Positionierungsplatte (356) hindurchtreten, die sich über den Führungsstangen (355) befindet, und eine Vielzahl von Verbindungsplatten (357), die mit der oberen Gussformhalterung (352) und der unteren Gussformhalterung (353) verbunden sind, umfasst, wobei die zwei Energiequellen (353) fest an der Positionierungsplatte (356) eingerichtet sind, wobei ein Ende jeder Energiequelle (353) mit einer Teleskopwelle (3541) versehen ist und ein Ende der Teleskopwelle (3541) fest mit der Außenfläche der oberen Gussformhalterung (352) verbunden ist, wobei, wenn die zwei Energiequellen (354) arbeiten, die obere Gussformhalterung (352) angetrieben wird, um sich auf und ab zu bewegen, wobei eine bewegbare Gussformplatte (358) auf der Außenfläche der oberen Gussformhalterung (352) eingerichtet ist, die der unteren Gussformhalterung (353) entspricht, und ein Prägemuster auf der Außenfläche der Gussformplatte (358) geformt ist, wobei das Prägemuster eine konkav-konvexe Struktur aufweist, die dazu entworfen ist, einem bestimmten Teil der Musterschicht (42) zu entsprechen.

7. Verfahren zum Formen von stereoskopischen Mustern (44) von Kunststoffbodenbrettern nach Anspruch 1 oder 3, wobei die Digitaldruckeinheit (10) einen ersten Maschinenkörper (11), eine erste Förderplattform (12), die auf dem ersten Maschinenkörper (11) eingerichtet ist, und einen Druckmechanismus (13), der entsprechend über der ersten Förderplattform (12) eingerichtet ist, umfasst, wobei der Druckmechanismus (13) einen Sammelsitz (131) umfasst, wobei ein Ende des Sammelsitzes (131) mit einer Quelle zum Zuführen des Pigments verbunden ist und das andere Ende des Sammelsitzes (131) mit einem Austragsteil (132) zum Austragen des Pigments versehen ist, wobei der Druckmechanismus (13) von dem elektrischen Steuersystem (50) gesteuert wird, wobei, wenn das Basisbrett (40) zu einer bestimmten Position befördert wird, der Druckmechanismus (13) dazu gesteuert wird, das Pigment durch den Austragsteil (132) gemäß dem Muster, das in dem elektrischen Steuersystem (50) voreingestellt ist, auf die Außenfläche (41) des Basisbretts (40) zu drucken, wodurch eine Musterschicht (42) geformt wird.

8. Verfahren zum Formen von stereoskopischen Mustern (44) von Kunststoffbodenbrettern nach Anspruch 1, 4 oder 5, wobei, wenn ein stereoskopisches Muster (44) durch die zweite Formungseinheit (30) auf dem Basisbrett (40) geformt wird, das Basisbrett (40) in einer bestimmten Position positioniert wird, wobei ein Positionierungspunkt (45) in einer korrekten Position auf dem Basisbrett (40) zuvor eingerichtet wird oder eine Vielzahl von Positionierungspunkten auf dem Basisbrett (40) in gleichen Abständen eingerichtet wird, wobei, wenn ein Positionierungspunkt (45) von dem elektrischen Steuersystem (50) erkannt wird, die zweite Formungseinheit (30) dazu gesteuert wird, ein stereoskopisches Muster (44) mit einer konkav-konvexen Struktur auf der Schutzschicht (43) zu formen, und jedes stereoskopische Muster (44) durch Positionieren des Positionierungspunkts (45) in einer bestimmten Position auf der entsprechenden Musterschicht (42) geformt wird.

## Revendications

1. Un procédé de formation de motifs stéréoscopiques (44) de lames de plancher en plastique, comprenant les étapes suivantes :
Étape A : prendre une plaque de base (40), qui a une surface extérieure vierge ou unie (41) ;
Étape B : impression numérique : positionnement de la plaque de base (40) sur une unité d'impression numérique
(10), et en utilisant l'unité d'impression numérique (10) pour imprimer le pigment sur la surface extérieure
(41) de la plaque de base (40) selon le motif prédéfini, formant ainsi une couche de motif (42), dans lequel le motif de la couche de motif (42) correspond ou ne correspond pas au motif stéréoscopique (44) ;
Étape C : former une couche de protection (43) : en utilisant une première unité de formation (20) pour former une couche de protection (43) sur la couche de motif (42) avec une matière première en plastique fondue transparente ;
Étape D : former un motif stéréoscopique (44) : en utilisant une seconde unité de formation (30) pour former un motif stéréoscopique (44) ayant une structure concave convexe sur la couche de protection (43), formant ainsi la lame de plancher en plastique avec un motif stéréoscopique (44) ; dans lequel la première unité de formation (20) comprend un second corps de machine (21), une seconde plate-forme transporteuse (22) disposée sur le second corps de machine (21), et un mécanisme d'enduction (23) disposé de manière correspondante au-dessus de la seconde plate-forme transporteuse (22), dans lequel, la seconde plate-forme transporteuse (22) comprend en outre deux roues de transport (221), une pluralité de roues de roulement (222) et une bande transporteuse (223), dans lequel, le mécanisme d'enduction (23) comprend un rouleau principal (231) et un rouleau auxiliaire (232), et une partie de réception (233) est disposée entre les deux rouleaux pour recevoir la matière première plastique fondue, dans lequel, le mécanisme d'enduction (23) est commandé par le système de commande électrique (50), dans lequel, lorsque la plaque de base (40) est transportée vers une position particulière, la matière première plastique fondue dans la partie de réception (233) est enduite sur la couche de motif (42) le long de la rotation du rouleau principal (231), grâce au rouleau auxiliaire (232) et au rouleau principal (231) qui tournent en directions opposées, le revêtement de la matière première plastique fondue devient plus uniforme ; une troisième plate-forme transporteuse (24) disposée sur le second corps de machine (21) et un mécanisme de revêtement de douche (25) disposé de manière correspondante au-dessus de la troisième plate-forme transporteuse (24), dans lequel, la troisième plate-forme transporteuse (24) comprend une pluralité de roues transporteuse (241) capable de propulser la bande transporteuse (233) en rotation, dans lequel, l'extrémité inférieure du mécanisme de revêtement de douche (25) étant pourvue d'un orifice de décharge (251) dont l'intérieur permet à la matière première plastique fondue de s'y écouler, dans lequel, la matière première plastique fondue se décharge verticalement à partir de l'orifice de décharge (251) à la manière d'une douche, lorsque la plaque de base (40) est transportée à travers la partie inférieure du mécanisme de revêtement de douche (25), la matière première plastique fondue est appliquée sur la couche de motif (42).

2. Un procédé de formation de motifs stéréoscopiques (44) de lames de plancher en plastique selon la revendication 1, dans lequel le matériau plastique utilisé comme couche de protection (43) est un revêtement UV, un matériau PVC ou un revêtement PUR.

3. Un procédé de formation de motifs stéréoscopiques (44) de lames de plancher en plastique selon la revendication 1, dans lequel, lors de l'impression du pigment sur la surface extérieure (41) de la plaque de base (40) par une unité d'impression numérique (10), l'étape B peut être répétée pour obtenir une couche de motif (42) avec une hauteur spécifique.

4. Un procédé de formation de motifs stéréoscopiques (44) de lames de plancher en plastique selon la revendication 1, dans lequel la seconde unité de formation (30) comprend deux roues de roulement (31, 32), et un motif en relief (311) ayant une structure concave convexe est formé sur l'une des roues de roulement, dans lequel la structure concave convexe du motif en relief (311) est conçue pour correspondre à une partie particulière de la couche de motif (42), dans lequel après que la plaque de base (40) passe à travers la seconde unité de formation (30), un motif stéréoscopique (44) avec une structure concave convexe est formé sur la couche de protection (43).

5. Un procédé de formation de motifs stéréoscopiques (44) de lames de plancher en plastique selon la revendication 1, dans lequel la seconde unité de formation (30) est un second mécanisme de revêtement (33) disposé sur une plate-forme (34), dans lequel une extrémité du second mécanisme de revêtement (33) est connectée à une source d'alimentation en matière première plastique fondue, et l'autre extrémité du second mécanisme de revêtement (33) délivre la matière première plastique fondue, dans lequel le second mécanisme de revêtement (33) est commandé par le système de commande électrique (50), dans lequel, après séchage de la couche de protection (43), un motif stéréoscopique (44) avec une structure en relief est formé sur la couche de protection (43) par revêtement au rouleau ou par revêtement par pulvérisation.

6. Un procédé de formation de motifs stéréoscopiques (44) de lames de plancher en plastique selon la revendication 5, dans lequel la seconde unité de formation (30) est un mécanisme de pressage comprenant un cadre de moule (351), un porte-moule supérieur (352), un porte-moule inférieur (353) et deux sources d'alimentation (354) étant disposées sur le cadre de moule (351), dans lequel le cadre de moule (351) comprend plusieurs tiges de guidage (355) traversant une plaque de positionnement (356) située au-dessus des tiges de guidage (355), et plusieurs plaques de liaison (357) reliées aux porte-moules supérieur (352) et inférieur (353), dans lequel les deux sources d'alimentation (353) sont fixées sur la plaque de positionnement (356), dans lequel, une extrémité de chaque source d'alimentation (353) est munie d'un arbre télescopique (3541), et une extrémité de l'arbre télescopique (3541) est fixée à la surface extérieure du porte-moule supérieur (352), dans lequel, lorsque les deux sources d'alimentation (354) fonctionnent, le support de moule supérieur (352) est propulsé pour se déplacer de haut en bas, dans lequel une plaque de moule mobile (358) étant disposée sur la surface extérieure du support de moule supérieur (352) qui correspond au support de moule inférieur (353), et un motif de relief étant formé sur la surface extérieure de la plaque de moule (358), dans lequel le motif de relief ayant une structure concave convexe, qui est conçue pour correspondre à une partie particulière de la couche de motif (42).

7. Un procédé de formation de motifs stéréoscopiques (44) sur des lames de plancher en plastique selon la revendication 1 ou 3, dans lequel l'unité d'impression numérique (10) comprend un premier corps de machine (11), une première plate-forme transporteuse (12) disposée sur le premier corps de machine (11) et un mécanisme d'impression (13) disposé au-dessus de la première plate-forme transporteuse (12), dans lequel le mécanisme d'impression (13) comprend un siège de collecte (131), dont une extrémité du siège de collecte (131) est reliée à une source d'alimentation en pigment, et l'autre extrémité est dotée du siège de collecte (131) d'une partie de décharge (132) pour la décharge du pigment, dans lequel le mécanisme d'impression (13) est commandé par le système de commande électrique (50), dans lequel lorsque la plaque de base (40) est transportée vers une position particulière, le mécanisme d'impression (13) est commandé pour imprimer le pigment sur la surface extérieure (41) de la plaque de base (40) à travers la partie de décharge (132) selon le motif prédéfini par le système de commande électrique (50), formant ainsi une couche de motif. (42).

8. Un procédé de formation de motifs stéréoscopiques (44) de lames de plancher en plastique selon la revendication 1, 4 ou 5, dans lequel, lors de la formation d'un motif stéréoscopique (44) sur la plaque de base (40) par la seconde unité de formation (30), la plaque de base (40) est positionnée à une position particulière, dans lequel un point de positionnement (45) est prédisposé à une position appropriée sur la plaque de base (40), ou une pluralité de points de positionnement est disposée sur la plaque de base (40) à intervalles égaux, dans lequel, lorsqu'un point de positionnement (45) est détecté par le système de commande électrique (50), la seconde unité de formation (30) est commandée pour former un motif stéréoscopique (44) ayant une structure concave convexe sur la couche de protection (43), et chaque motif stéréoscopique (44) est formé à une position particulière sur la couche de motif correspondante (42) par le positionnement du point de positionnement (45).
